# EUROPEAN PATENT APPLICATION

(11) **EP 1 087 525 A2**
(43) Date of publication of application: **28.03.2001**
(21) Application number: 00120019.5
(22) Date of filing: 14.09.2000
(51) Int. Cl.: H03H 9/17

(54) **Piezoelectric device**

(30) Priority: 22.09.1999 JP 26865199; 31.05.2000 JP 2000161833; 27.03.2000 JP 2000086995; 31.05.2000 JP 2000161834; 27.03.2000 JP 2000086996; 31.05.2000 JP 2000161835
(71) Applicant: Murata Manufacturing Co., Ltd., Nagaokakyo-shi Kyoto-fu 617-8555 (JP)
(72) Inventor: Ando, Akira, c/o Murata Manufacturing Co., Ltd., Nagaokakyo-shi, Kyoto-fu 617-8555 (JP); Kimura, Masahiko, c/o Murata Manufacturing Co.,Ltd, Nagaokakyo-shi, Kyoto-fu 617-8555 (JP); Sawada, Takuya, c/o Murata Manufacturing Co., Ltd., Nagaokakyo-shi, Kyoto-fu 617-8555 (JP)
(74) Representative: Gossel, Hans K., Dipl.-Ing.

(57) **Abstract**

A piezoelectric device operable to excite a thickness extensional third harmonic vibration is provided, which can realize a high performance oscillator with an excellent thermal stability. The piezoelectric device includes a piezoelectric substrate. The piezoelectric substrate is formed from a piezoelectric material containing as major components Sr, Bi, Nb, and O. Vibration electrodes are formed on both of the surfaces of the piezoelectric substrate. The range lying between the vibration electrodes and defined by the overlapped vibration electrodes constitutes an energy trapping range. The value L/t is set to be less than 9, in which L represents the maximum distance between the points at which a straight line parallel to the vibration electrodes intersects the outer circumference of the energy-trapping range, and t represents the distance between the vibration electrodes.

## Description

The present invention relates to a piezoelectric device, and more particularly to an energy trapping type piezoelectric device operable to use, e.g., a thickness extensional third harmonic vibration.

Conventionally, energy trapping piezoelectric devices have been proposed, each of which has one pair of energy trapping vibration electrodes formed on both of the surfaces of a piezoelectric substrate to excite a thickness extensional third harmonic vibration. For the same material, the thickness extensional third harmonic vibration has the frequency constant which is about three times larger than that of the fundamental wave. Accordingly, for piezoelectric devices operable to use a fundamental wave, the upper limit of the center frequency is about 15 MHz, considering the restrictions in strength of the piezoelectric substrates. On the other hand, the upper limits in center frequency of piezoelectric device operable to use third harmonic waves are about 30 to 40 MHz. That is, the piezoelectric device can be applied in a higher frequency range.

However, regarding the energy trapping piezoelectric devices operable to excite a thickness extensional third harmonic vibration, the optimum electrode structures are different, depending on material types. Thus, it is necessary to determine the optimum electrode size for each material type. In particular, it is well known that in an energy trapping piezoelectric device, the resonant frequency of spurious vibration, called an unharmonic overtone, is present near to the resonant frequency of the principal vibration. The unharmonic overtone, when the electrode size, namely, the energy trapping range is small, is not excited. The maximum in the electrode size range where the unharmonic overtone is not excited depends on material types. Accordingly, it is necessary to determine the maximum electrode size for each material type. Unoriented bismuth layer-structure compound type ceramic materials have an excellent thermal stability. Thus, the realization of high performance piezoelectric devices is expectable. However, for the energy trapping piezoelectric devices operable to excite a thickness extensional third harmonic vibration, the maximums in the electrode size ranges where unharmonic overtones are not excited have not been found.

### SUMMARY OF THE INVENTION

Accordingly, it is an object of the present invention to provide a piezoelectric device with which a high performance oscillator with an excellent thermal stability can be realized.

To achieve the above object, according to the present invention, there is provided a piezoelectric device which comprises a piezoelectric substrate comprising a piezoelectric material containing as major components Sr, Bi, Nb, and O, and at least one pair of vibration electrodes formed on both of the faces of the piezoelectric substrate so as to be opposed to each other, being operable to excite a thickness extensional third harmonic wave in the energy trapping range defined by the overlapping electrodes formed on both of the faces of the piezoelectric substrate in opposition to each other, the value L/t being less than 9, in which L represents the maximum distance between the points at which a straight line parallel to the vibration electrodes intersects the outer circumference of the energy-trapping range, and t represents the distance between the vibration electrodes.

Preferably, in the piezoelectric device, as a major component, SrBi₂Nb₂O₉ is employed.

A piezoelectric material containing Sr, Bi, Nb, and O as major components, such as SrBi₂Nb₂O₉ is thermally stable. If such a material is used to produce a piezoelectric device operable to excit a thickness extensional third harmonic vibration, and the value L/t is set to be less than 9, superposition of an unharmonic overtone can be avoided, and good energy-trapping can be performed.

Here, if the plan shape of the energy trapping range is circular, the reference character L represents the diameter of the circle. If the shape is elliptic, L represents the longer axis. If the shape is a rectangle or square, L represents the length of a diagonal line. In addition, a piezoelectric material containing Ca, Bi, Ti, and O as major components, and a piezoelectric material containing Sr, Bi, Ti, and O as major components are be employed.

### BRIEF DESCRIPTION OF THE DRAWINGS

Fig. 1 illustrates an example of the piezoelectric device of the present invention;
Fig. 2 illustrates the side of the piezoelectric device of Fig. 1;
Fig. 3 illustrates a circuit diagram for estimating a piezoelectric device;
Fig. 4 is a graph showing the frequency characteristic of an impedance at an energy trapping range diameter of 3.6 mm;
Fig. 5 is a graph showing the top-to-bottom ratio of the impedance in the piezoelectric device of Example 1 at different L/t values;
Fig. 6 illustrates a further example of the piezoelectric device of the present invention;
Fig. 7 is a graph showing the frequency characteristic of the impedance at an energy trapping range diameter of 3.6mm in the Example 2;
Fig. 8 is a graph showing the top-to-bottom ratio of the impedance of the piezoelectric device of Example 2 at different L/t values.
Fig. 9 is a graph showing the frequency characteristic of the impedance at an energy trapping range diameter of 3.6 mm in Example 3; and
Fig. 10 is a graph showing the top-to-bottom ratio of the impedance of the piezoelectric device of Example 3 at different L/t values.

### DESCRIPTION OF THE PREFERRED EMBODIMENTS

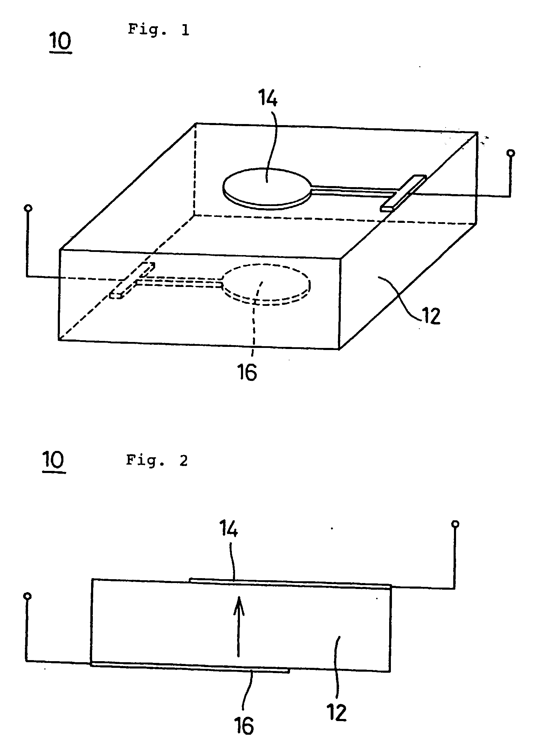

Fig. 1 illustrates an example of an piezoelectric device of the present invention. Fig. 2 illustrates the side face of the piezoelectric device. A piezoelectric device 10 contains a piezoelectric substrate 12. The piezoelectric substrate 12 is formed from a piezoelectric ceramic material containing as major components Sr, Bi, Nb, and O. As the piezoelectric material, for example, a material containing SrBi₂Nb₂O₉ as a major component is employed. Circular vibration electrodes 14 and 16 are formed substantially in the centers of both of the faces of the piezoelectric substrate 12 so as to be opposed to each other. The vibration electrodes 14 and 16 are led out to the end portions opposed to each other of the piezoelectric substrate 12. The vibration electrodes 14 and 16 are formed so as to have a substantially equal diameter. The piezoelectric substrate 12 is polarized, e.g., in the direction from the vibration electrode 16 side to the vibration electrode 14 side. Needless to say, the piezoelectric substrate 12 may be polarized in the direction from the vibration electrode 14 side to the vibration electrode 16 side.

This piezoelectric device 10 is applied as an energy-trapping type piezoelectric device. The portion of the piezoelectric device 10 lying between the vibration electrodes 14 and 15 and defined by the overlapping vibration electrodes 14 and 15 constitutes an energy-trapping range. Here, the maximum distance L between the points at which a straight line in parallel to the vibration electrodes 14 and 16 intersects the outer circumference of the energy-trapping range, namely, the diameter L of the circular portion of each of the vibration electrodes 14 and 16 in the piezoelectric device 10 of Fig. 1, and the distance t between the vibration electrodes 14 and 16 are set in such a manner that the value L/t is less than 9.

The piezoelectric device 10, formed from a piezoelectric material containing Sr, Bi, Nb, and O as major components such as SrBi₂Nb₂O₉ or the like, can be used as a high performance oscillator having a high thermal stability. Further, the piezoelectric device, having the value L/t set at less than 9, can be prevented from exciting an unharmonic overtone.

### Example 1

First, as starting materials, SrCO₃, Bi₂O₃, Nb₂O₅, and MnCO₃ were prepared. These raw materials were weighed out and mixed in such amounts as to produce a composition of SrBi₂Nb₂O₉ + 1 wt.% MnCO₃. The mixed powder was calcined at a temperature of 800 to 1000°C. An appropriate amount of an organic binder was added, and wet-pulverized for four hours by means a ball mill. The grain size was adjusted by passing the powder through a 40 mesh sieve.

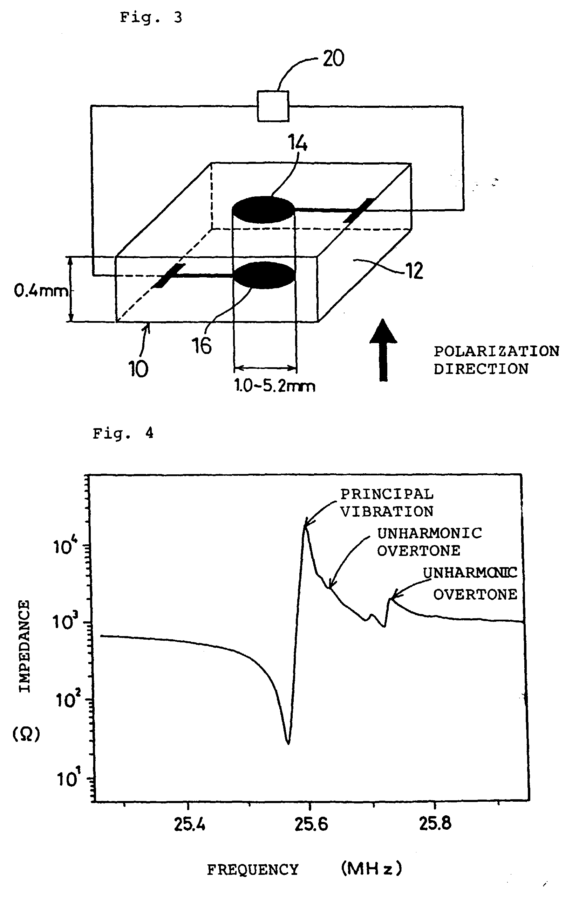

The raw material of which the grain size was adjusted was molded under a pressure of 1000 kg/cm² into a rectangular sheet with a size of 30 mm × 20 mm × 1.0 mm thick, and fired at a temperature of 1250 to 1300°C for 1 to 5 hours in the atmosphere to produce a porcelain having a rectangular sheet shape. The porcelain was cut and polished to form a square sheet of 5 mm × 5 mm × 0.4 mm thick. The square sheet was polarized in the thickness direction. Further, silver electrodes were formed by vapor-deposition on both of the main faces as shown in Fig. 3. Thus, a piezoelectric device having a structure as shown in Figs. 1 and 2 was formed. The thickness of the formed porcelain substrate was 0.4 mm. Accordingly, the distance between the vibration electrodes formed on both of the main faces was 0.4 mm. In the obtained piezoelectric device, the diameter of the energy trapping range, that is, the diameter of the circular portion of each of the vibration electrodes was set to be in the range of 1.0 to 5.2 mm.

For the purpose of estimating the energy trapping performance of the above-described piezoelectric device for a third harmonic wave, an impedance analyzer 20 was connected, as shown in Fig. 4, and the frequency characteristic of the impedance was measured. Fig. 4 is a graph showing the impedance - frequency characteristic at an electrode diameter of 3.6 mm. In this case, L is 3.6 mm, and t is 0.4 mm, that is, the value L/t is 9. It is seen that in the piezoelectric device, unharmonic overtones are superposed on the resonant frequencies of the principal vibration.

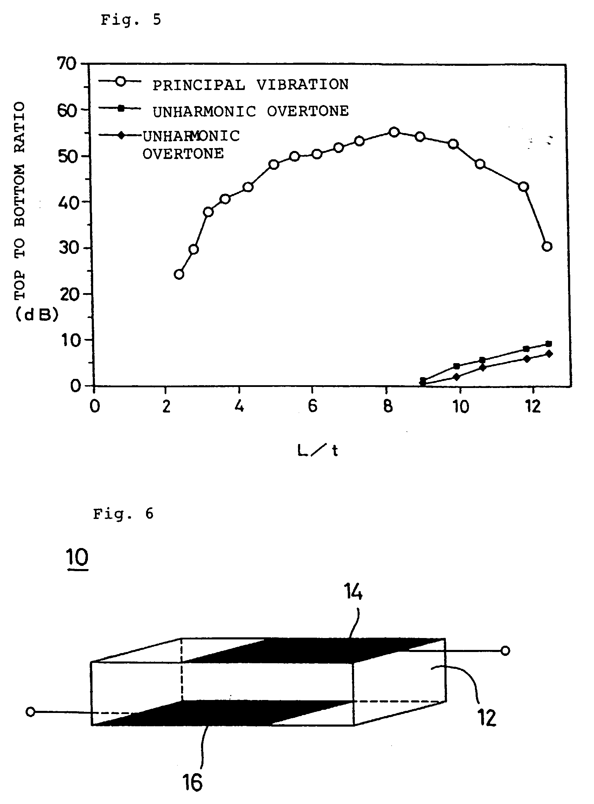

Fig. 5 shows the relations of the index L/t to the top-to-bottom ratios (the ratio of the resonant impedance to the anti-resoanct impedance) of the principal vibration and the unharmonic overtones. As seen in Fig. 5, the unharmonic overtone are superposed when the value L/t is 9 or higher. When the piezoelectric device is used as an oscillator, the unharmonic overtone causes abnormal oscillation, termination of oscillation, and so forth. Further, when the piezoelectric device is used as a filter, the unharmonic overtone causes the problems that the attenuation is decreased, and so forth.

As described above, regarding the piezoelectric device which has at least one pair of energy-trapping vibration electrodes formed on both of the faces of a piezoelectric substrate comprising a material containing as major components Sr, Bi, Nb, and O such as SrBi₂Nb₂O₉, which is a bismuth layer-structure compound type material, in opposition to each other at both of the faces of the piezoelectric substrate, and excites a thickness extensional third harmonic wave, can be used in a high performance piezoelectric resonator with an excellent thermal resistance by setting the size of the electrodes to have the value L/t of less than 9.

In the piezoelectric device of Fig. 1, the energy-trapping electrodes have a circular shape. The shape may be elliptical, or may be a square, a rectangle, or another polygon. In theses cases, L represents the length in a longest portion. That is, in these shapes, the reference character L represents the length of a longest portion, respectively. In an ellipse, L represents the length of the longer axis. In a square or rectangle, L represents the length of a diagonal line. Further, the electrodes including the lead-out portions may have a rectangular shape□as shown in Fig. 6. In this case, the portion of the device defined by the electrodes 14 and 16 overlapped to each other constitutes an energy trapping range.

In the above-described example, used was the material having a composition containing SrBi₂Nb₂O₉ as a major component, to which Mn was added. Such materials to which Si and W are added may be employed. Further, such materials are available in which at a part of the Sr and Nb positions, other elements are substituted. Moreover, for the purpose of improving the sintering properties of ceramics, an assisting agent such as a glass component may be added to a composition containing Sr, Bi, Nb, and O as major components.

The major component of the piezoelectric material used for the piezoelectric device of this example is SrBi₂Nb₂O₉. However, the ratio in number of the elements may be different from the above composition to some degree, provided that the major compound essentially takes the crystal structure of SrBi₂Nb₂O₉, not departing from the scope of the present invention. Also in this case, the advantages of the present invention can be attained.

In the present invention, at least one pair of the vibration electrodes are formed at both of the faces of the piezoelectric substrate so as to be opposed to each other. However, it is not necessary to provide the electrodes on the outermost parts of the whole of the device. For example, piezoelectric layers may be formed on the outsides of the vibration electrodes in the thickness direction. However, it is preferable that the vibration electrodes are external electrodes, that is, the electrodes are formed on the outermost parts of the whole of the device without piezoelectric layers provided on the outsides of the electrodes. In particular, in the case in which the piezoelectric device is used for an oscillator or a filter, it is necessary to adjust the resonant frequency at a desired value. The resonant frequency of the piezoelectric device depends on a piezoelectric material constituting the piezoelectric device, types of the electrodes, the thickness of the device, and so forth. In many cases, for final adjustment, employed is a method of applying a coating material or the like to the vibration electrodes, and drying to provide a mass load for the vibration electrodes. Thus, the above technique for adjusting the resonant frequency can be easily applied, when the vibration electrodes are external electrodes and are exposed to the outside of the device. Further, similarly, there are some cases in which for suppression of spurious vibration, a mass load is provided on the vibration electrodes by application of a coating material or the like. In these cases, it is also preferable that the vibration electrodes are formed as external electrodes. As described above, if outermost vibration electrodes are external electrodes, a variety of actions on the vibration electrodes can be easily performed.

A high performance resonator with an excellent thermal resistance can be provided by use of the piezoelectric device of the present invention.

### Example 2

First, as starting materials, SrCO₃, Bi₂O₃, TiO₂, and MnCO₃ were prepared. These raw materials were weighed out and mixed in such amounts as to produce a composition of SrBi₄Ti₄O₁₅ + 1 wt.% MnCO₃. The mixed powder was calcined at a temperature of 800 to 1000°C. Thereafter, an appropriate amount of an organic binder was added, and wet-pulverized for four hours by means of a ball mill. The grain size was adjusted by passing the powder through a 40 mesh sieve.

The raw material of which the grain size was adjusted was molded under a pressure of 1000 kg/cm² into a rectangular sheet with a size of 40 mm × 25 mm × 1.2 mm thick, and fired at a temperature of 1150 to 1300°C for 1 to 5 hours in the atmosphere to produce a porcelain having a rectangular sheet shape. The porcelain was cut and polished to form a square sheet of 5 mm × 5 mm × 0.4 mm thick. The square sheet was polarized in thickness direction. Further, silver electrodes were formed by vapor-deposition on both of the main faces as shown in Fig. 3. Thus, a piezoelectric device having a structure as illustrated in Figs. 1 and 2 was formed. In the produced piezoelectric device, the diameter of the energy trapping range, that is, the diameter of the circular portion of each of the vibration electrodes was set to be in the range of 1.0 to 5.2 mm.

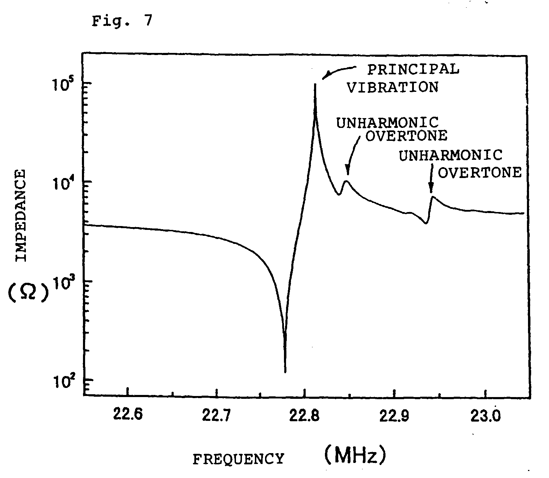

For the purpose of estimating the energy trapping performance for a third harmonic wave of the piezoelectric device, an impedance analyzer 20 was connected, as shown in Fig. 3, and the frequency characteristic of the impedance was measured. Fig. 7 is a graph showing the impedance - frequency characteristic at an electrode diameter of 3.6 mm. In this case, L is 3.6 mm, and t is 0.4 mm, that is, the value L/t is 9. It is seen that in the piezoelectric device, unharmonic overtones are superposed on the resonant frequencies of the principal vibration.

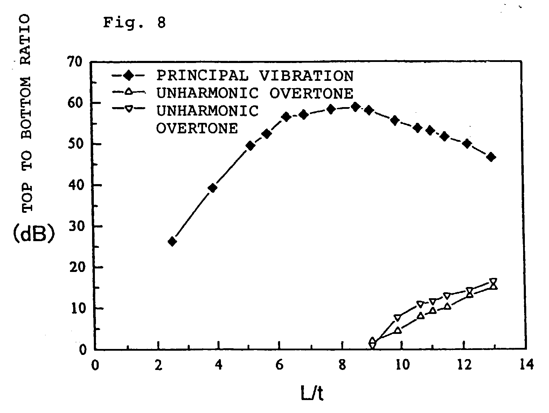

Fig. 8 shows the relations of the index L/t to the top-to-bottom ratios (the ratio of the resonant impedance to the anti-resonant impedance) of the principal vibration and the unharmonic overtones. As seen in Fig. 8, the unharmonic overtones are superposed when the value L/t is 9 and higher. If the piezoelectric device is used for an oscillator, the unharmonic overtones will cause abnormal oscillation, termination of oscillation, and so forth. Further, if the piezoelectric device is used for a filter, the unharmonic overtones cause the problems that the attenuation is decreased, and so forth.

As described above, the piezoelectric device which has at least one pair of energy-trapping vibration electrodes formed on both of the faces of a piezoelectric substrate comprising a material containing as a major component SrBi₄Ti₄O₁₅, which is a bismuth layer-structure compound type material, in opposition to each other, and excites a thickness extensional third harmonic wave can be used for a high performance piezoelectric resonator with an excellent thermal resistance by setting the size of the electrodes to have the value L/t of less than 9.

The composition containing SrBi₄Ti₄O₁₅ as a major component, to which Mn was added was used. Such materials to which Si and W are added may be employed. Further, such materials are available in which at a part of the Sr and Ti positions, other elements are substituted. Moreover, for the purpose of improving the sintering properties of ceramics, an assisting agent such as a glass component may be added to the composition containing SrBi₄Ti₄O₁₅ as a major component.

The major component of the piezoelectric material used for the piezoelectric device of this example includes Sr, Bi, Ti, and O, and is e.g., SrBi₄Ti₄O₁₅. However, the ratio in number of the elements may be different from the above composition to some degree, provided that the compound substantially takes the crystal structure of SrBi₄Ti₄O₁₅, not departing from the scope of the present invention. Also in this case, the advantages of the present invention can be attained.

### Example 3

First, as starting materials, CaCO₃, Bi₂O₃, TiO₂, and MnCO₃ were prepared. These raw materials were weighed out and mixed in such amounts as to produce a composition of CaBi₄Ti₄O₁₅ + 1 wt.% MnCO₃. The mixed powder was calcined at a temperature of 800 to 1000°C. Thereafter, an appropriate amount of an organic binder was added, and wet-pulverized for four hours by means of a ball mill. The grain size was adjusted by passing the powder through a 40 mesh sieve.

The raw material of which the grain size was adjusted was molded under a pressure of 1000 kg/cm² into a rectangular sheet with a size of 40 mm × 30 mm × 1.0 mm thick, and fired at a temperature of 1100 to 1300°C for 1 to 5 hours in the atmosphere to produce a porcelain having a rectangular sheet shape. The porcelain was cut and polished to form a square sheet of 5.5 mm × 5.5 mm × 0.4 mm thick. The square sheet was polarized in the thickness direction. Further, silver electrodes were formed by vapor-deposition on both of the main faces as shown in Fig. 3. Thus, a piezoelectric device having a structure as illustrated in Figs. 1 and 2 was formed. In the produced piezoelectric device, the diameter of the energy trapping range, that is, the diameter of the circular portion of each of the vibration electrodes was set to be in the range of 1.0 to 5.2 mm.

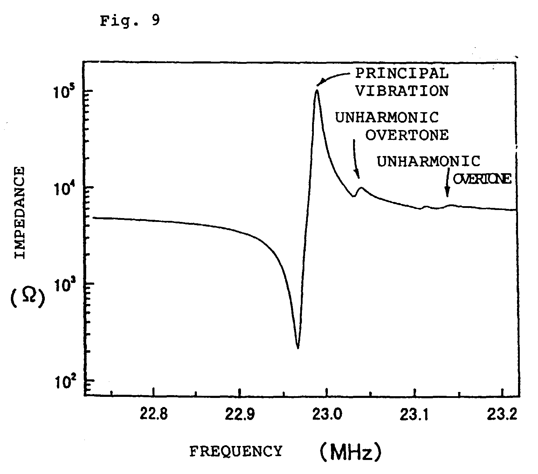

For the purpose of estimating the energy trapping performance for a third harmonic wave of the piezoelectric device, an impedance analyzer 20 was connected, as shown in Fig. 3, and the frequency characteristic of the impedance was measured. Fig. 9 is a graph showing the impedance - frequency characteristic at an electrode diameter of 3.6 mm. In this case, L is 3.6 mm, and t is 0.4 mm, that is, the value L/t is 9. It is seen that in the piezoelectric device, the unharmonic overtones are superposed on the resonant frequencies of the principal vibration.

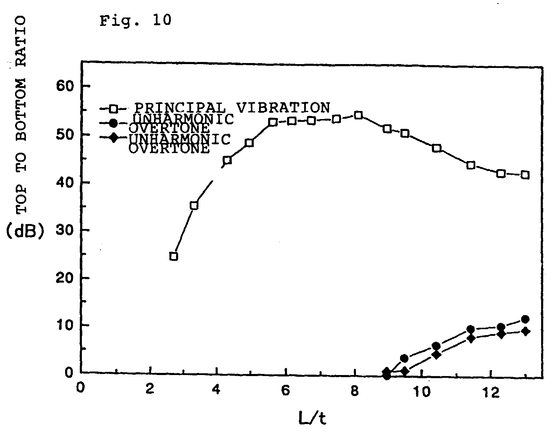

Fig. 10 shows the relations of the index L/t to the top-to-bottom ratios (the ratio of the resonant impedance to the anti-resonant impedance) of the principal vibration and the unharmonic overtones. As seen in Fig. 10, the unharmonic overtones are superposed when the value L/t is 9 and higher. If the piezoelectric device is used for an oscillator, the unharmonic overtones will cause abnormal oscillation, termination of oscillation, and so forth. Further, if the piezoelectric device is used for a filter, the unharmonic overtones cause the problems that the attenuation is decreased, and so forth.

As described above, the piezoelectric device which has at least one pair of energy-trapping vibration electrodes formed on both of the faces of a piezoelectric substrate comprising a material containing as a major component CaBi₄Ti₄O₁₅, which is a bismuth layer-structure compound type material, in opposition to each other, and excites a thickness extensional third harmonic wave, can be used for a high performance piezoelectric resonator with an excellent thermal resistance by setting the size of the electrodes to have the value L/t of less than 9.

To the composition containing CaBi₂Ti₄O₁₅ as a major component, to which Mn was added, was used. Such materials to which, e.g., Si and W are added may be used. Further, such materials in which at a part of the Ca and Ti positions, other elements are substituted may be employed. Furthermore, such compositions containing CaBi₂Ti₄O₁₅ as a major component, to which an assisting agent such as a glass component is added in order to improve the sintering properties of ceramics, are available.

The major component of the piezoelectric material used in a piezoelectric device in accordance with the present invention includes Ca, Bi, Ti, and O, and is, e.g., Ca₂Bi₄Ti₄O₁₅. However, the ratio in number of the elements may be different from the above composition, provided that the material substantially takes the crystal structure of CaBi₄Ti₄O₁₅, not departing from the scope of the present invention. In this case, the advantages of the present invention can be also attained.

## Claims

1. A piezoelectric device comprising a piezoelectric substrate comprising a piezoelectric material containing as major components Sr, Bi, Nb, and O, and
at least one pair of vibration electrodes formed on both of the faces of the piezoelectric substrate so as to be opposed to each other,
being operable to excite a thickness extensional third harmonic wave in the energy trapping range defined by the overlapping electrodes formed on both of the faces of the piezoelectric substrate in opposition to each other,
the value L/t being less than 9, in which L represents the maximum distance between the points at which a straight line parallel to the vibration electrodes intersects the outer circumference of the energy-trapping range, and t represents the distance between the vibration electrodes.

2. A piezoelectric device according to claim 1, wherein a major component for the piezoelectric material is SrBi₂Nb₂O₉.

3. A piezoelectric device comprising a piezoelectric substrate comprising a piezoelectric material containing as major components Sr, Bi, Ti, and O, and
at least one pair of vibration electrodes formed on both of the faces of the piezoelectric substrate so as to be opposed to each other,
being operable to excite a thickness extensional third harmonic wave in the energy trapping range defined by the overlapping electrodes formed on both of the faces of the piezoelectric substrate in opposition to each other,
the value L/t being less than 9, in which L represents the maximum distance between the points at which a straight line parallel to the vibration electrodes intersects the outer circumference of the energy-trapping range, and t represents the distance between the vibration electrodes.

4. A piezoelectric device according to claim 3, wherein a major component for the piezoelectric material is SrBi₄Ti₄O₁₅.

5. A piezoelectric device comprising a piezoelectric substrate comprising a piezoelectric material containing as major components Ca, Bi, Ti, and O, and
at least one pair of vibration electrodes formed on both of the faces of the piezoelectric substrate so as to be opposed to each other,
being operable to excite a thickness extensional third harmonic wave in the energy trapping range defined by the overlapping electrodes formed on both of the faces of the piezoelectric substrate in opposition to each other,
the value L/t being less than 9, in which L represents the maximum distance between the points at which a straight line parallel to the vibration electrodes intersects the outer circumference of the energy-trapping range, and t represents the distance between the vibration electrodes.

6. A piezoelectric device according to claim 5, wherein a major component for the piezoelectric material is CaBi₄Ti₄O₁₅.
